(19) Europäisches Patentamt
European Patent Office
Office européen des brevets

(11) **EP 4 224 254 A1**

(12) **EUROPEAN PATENT APPLICATION**

(43) Date of publication:
**09.08.2023 Bulletin 2023/32**

(21) Application number: **22155168.2**

(22) Date of filing: **04.02.2022**

(51) International Patent Classification (IPC):
**G03F 7/20** (2006.01)   **G03F 9/00** (2006.01)

(52) Cooperative Patent Classification (CPC):
**G03F 9/7046; G03F 7/705; G03F 7/70616; G03F 7/70633**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **KOOLEN, Armand, Eugene, Albert**
**5500 AH Veldhoven (NL)**

• **CHENG, Su-Ting**
**5500 AH Veldhoven (NL)**
• **CRAMER, Hugo, Augustinus Joseph**
**5500 AH Veldhoven (NL)**
• **WANG, Kirsten, Jennifer, Lyhn**
**5500 AH, Veldhoven (NL)**

(74) Representative: **ASML Netherlands B.V.**
**Corporate Intellectual Property**
**P.O. Box 324**
**5500 AH Veldhoven (NL)**

(54) **METROLOGY METHOD AND ASSOCIATED METROLOGY DEVICE**

(57)     Disclosed is a method of determining a value for a parameter of interest from a target on a substrate. The method comprises obtaining metrology data comprising single-wavelength parameter of interest values which were obtained using a respective different measurement wavelength; and determining said value for the parameter of interest from a stack sensitivity derived weighted combination of said single-wavelength parameter of interest values. Also disclosed is a method of selecting wavelengths for a measurement based on at least the derivative of the stack sensitivity with respect to wavelength.

Fig. 7

**Description**

BACKGROUND

Field of the Invention

The present invention relates to a lithographic process and more specifically to a method to measure a parameter of a lithographic process.

Background Art

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., 40μm by 40μm, gratings and the measurement beam generates a spot that is smaller than the grating (i.e., the grating is underfilled). This simplifies mathematical reconstruction of the target as it can be regarded as infinite. However, in order to reduce the size of the targets, e.g., to 10μm by 10μm or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242970A. Modifications of the apparatus to improve throughput are described in US2010201963A1 and US2011102753A1. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

A known method of determining overlay from metrology images such as those obtained using dark-field methods, while making some correction for non-overlay asymmetry is known as the A+/A- regression method. This method comprises measuring a biased target having two differently biased sub-targets using radiation having at least two different wavelengths, and plotting intensity asymmetry from one of the sub-targets against intensity asymmetry from the other of the sub-targets for each wavelength. Regressing through each data point yields a line having a slope indicative of overlay.

There are a number of inherent drawbacks with this method. In particular wavelength selection for the measurements is limited to wavelengths which yield data points in A+/A- space which are sufficiently far apart to regress, e.g., such that at least two of the data points are in opposing quadrants of such a plot. This limitation maybe detrimental to the overlay inference as other combinations may be inherently more stable.

It would be desirable to enable measurement of overlay with pairs of wavelengths which are not usable in existing A+/A- regression methods. Alternatively or in addition, a method of cancelling nuisance contributors in overlay inference would be desirable.

SUMMARY OF THE INVENTION

The invention in a first aspect provides a method of determining a value for a parameter of interest from a target on a substrate, the method comprising: obtaining metrology data comprising at least two or more single-wavelength parameter of interest values, each single-wavelength parameter of interest value having been obtained using a respective different measurement wavelength; and determining said value for the parameter of interest from a weighted combination of said single-wavelength parameter of interest values, the weighted combination being weighted by a stack sensitivity derived weighting.

The invention in a second aspect provides a method of selecting two or more measurement wavelengths for measuring a parameter of interest from a target on a substrate, the method comprising: obtaining swing curve data describing stack sensitivity of the target in relation to wavelength; and selecting said two or more measurement wavelengths based on at least the derivative of the stack sensitivity with respect to wavelength.

The invention in other aspects provide a processing device, a metrology apparatus and a computer program being operable to perform the method of the first aspect and/or second aspect.

In a further aspect of the invention, there is provided a computer program comprising program instructions operable to perform the method of the first aspect when run on a suitable apparatus.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying drawings in which:

Figure 1 depicts a lithographic apparatus according to an embodiment of the invention;
Figure 2 depicts a lithographic cell or cluster according to an embodiment of the invention;
Figure 3 comprises (a) a schematic diagram of a dark field scatterometer for use in measuring targets using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
Figure 4 depicts a known form of multiple grating target and an outline of a measurement spot on a substrate;
Figure 5 depicts an image of the target of Figure 4 obtained in the scatterometer of Figure 3;
Figure 6 is a plot of normalized intensity asymmetry A+/I obtained from a positive biased sub-target against normalized intensity asymmetry A-/I obtained from a negative biased sub-target illustrating a known overlay inference method; and
Figure 7 is a swing curve plot of stack sensitivity against wavelength.

DETAILED DESCRIPTION OF EXEMPLARY EMBODIMENTS

Before describing embodiments of the invention in detail, it is instructive to present an example environment in which embodiments of the present invention may be implemented.

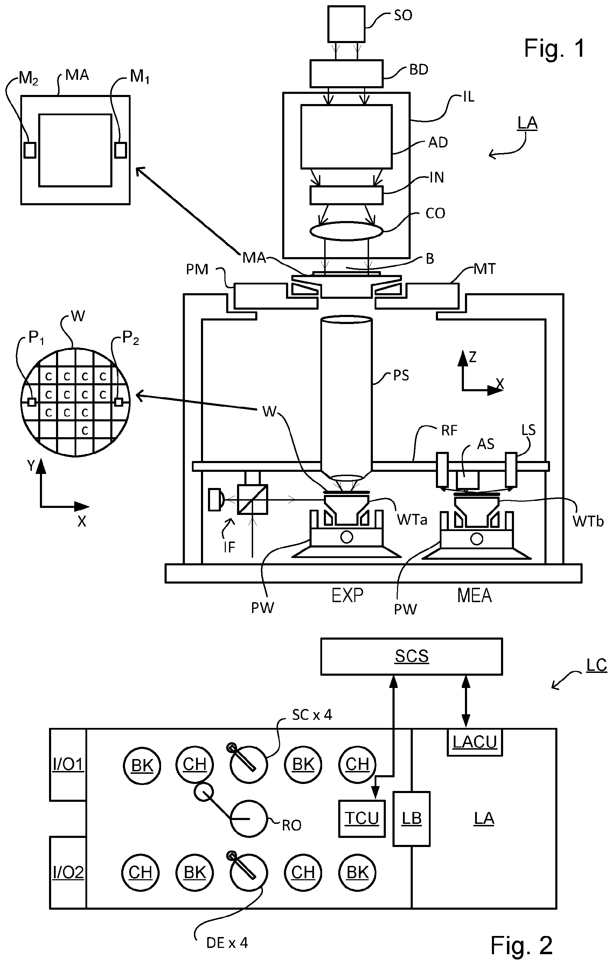

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WT constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical or non-optical components, such as refractive, reflective, magnetic, electromagnetic, electrostatic or other types of components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

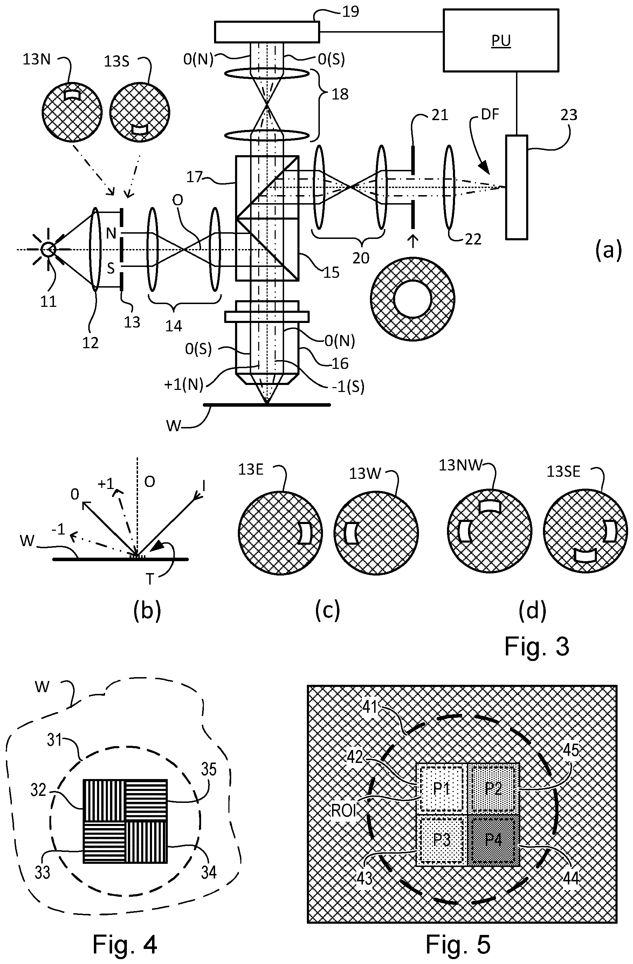

A metrology apparatus is shown in Figure 3(a). A target T and diffracted rays of measurement radiation used to illuminate the target are illustrated in more detail in Figure 3(b). The metrology apparatus illustrated is of a type known as a dark field metrology apparatus. The metrology apparatus depicted here is purely exemplary, to provide an explanation of dark field metrology. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 3(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 3) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d). The use of these, and numerous other variations and applications of the apparatus are described in prior published applications, mentioned above.

Figure 4 depicts an overlay target or composite overlay target formed on a substrate according to known practice. The overlay target in this example comprises four sub-targets (e.g., gratings) 32 to 35 positioned closely together so that they will all be within a measurement spot 31 formed by the metrology radiation illumination beam of the metrology apparatus. The four sub-overlay targets thus are all simultaneously illuminated and simultaneously imaged on sensor 23. In an example dedicated to measurement of overlay, sub-targets 32 to 35 are themselves composite structures formed by overlying gratings that are patterned in different layers of the semiconductor device formed on substrate W. Sub-targets 32 to 35 may have differently biased overlay offsets in order to facilitate measurement of overlay between the layers in which the different parts of the composite sub-targets are formed. Sub-targets 32 to 35 may also differ in their orientation, as shown, so as to diffract incoming radiation in X and Y directions. In one example, sub-targets 32 and 34 are X-direction sub-targets with biases of the +d, -d, respectively. Sub-targets 33 and 35 are Y-direction sub-targets with offsets +d and -d respectively. Separate images of these sub-targets can be identified in the image captured by sensor 23. This is only one example of an overlay target. An overlay target may comprise more or fewer than 4 sub-targets.

Figure 5 shows an example of an image that may be formed on and detected by the sensor 23, using the overlay target of Figure 4 in the apparatus of Figure 3, using the aperture plates 13NW or 13SE from Figure 3(d). While the pupil plane image sensor 19 cannot resolve the different individual sub-targets 32 to 35, the image sensor 23 can do so. The hatched area 40 represents the field of the image on the sensor, within which the illuminated spot 31 on the substrate is imaged into a corresponding circular area 41. Within this, rectangular areas 42-45 represent the images of the small overlay target sub-targets 32 to 35. If the overlay targets are located in product areas, product features may also be visible in the periphery of this image field. Image processor and controller PU processes these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the overlay targets have been identified, the intensities of those individual images can be measured, e.g., by averaging or summing selected pixel intensity values within the identified areas. Intensities and/or other properties of the images can be compared with one another. These results can be combined to measure different parameters of the lithographic process. Overlay performance is an important example of such a parameter.

A present method for determining overlay from an overlay target having (e.g., per direction) a positive biased target region and negative biased target region comprises determining the intensity asymmetry A+ of the positively biased region as function of the intensity asymmetry A- of the negatively biased region for two or more wavelengths and regressing a line in the A+/A- space through the data points for each wavelength. Overlay can be inferred from the slope of the regression, with the distance to origin of the regression (perpendicular to the regression) being indicative of non-overlay asymmetry (unwanted nuisance asymmetry) in the target. WO2015/018625A1, which is incorporated herein by reference, describes such an A+/A- method. In this context, intensity asymmetry describes a difference or imbalance (which may be intensity normalized) in a pair of complementary higher diffraction orders from each target region. Complementary diffraction orders in this context describes a pair of diffraction orders of the same order, typically the +1 and -1 diffraction orders, though higher order pairs may be used in principle. The intensity asymmetry measurements may, for example, comprise diffraction based overlay (DBO) measurements performed, for example, using dark-field metrology as has been described above.

This multi-wavelength A+/A- method is quite restrictive in its overlay inference method and wavelength selection due to intrinsic limitations. Furthermore, in addition to target-induced nuisance asymmetries (e.g. caused by bottom grating asymmetry BGA, side-wall angle difference $\Delta$SWA, floor tilt, and/or grating imbalance GI), a measurement may also suffer from sensor-induced nuisance asymmetries (e.g. caused by optical crosstalk, spot homogeneity SpoHo, and dark-field internal and/or external ghosts).

A+/A- regression methods typically operate in intensity normalized asymmetry space, represented by intensity normalized asymmetries $A^+/\bar{I}$ and $A^-/\bar{I}$ for each wavelength. Mathematically, these two wavelengths can be expressed in overlay contributions $A^{\pm}_{OV}$ and nuisance contributions $A^{\pm}_{nuis}$ in the following way:

$$A^{\pm}_1 = A^{\pm}_{OV,1} + A^{\pm}_{nuis,1} = K_1(OV \pm d) + A^{\pm}_{nuis,1}$$

$$A^{\pm}_2 = A^{\pm}_{OV,2} + A^{\pm}_{nuis,2} = K_2(OV \pm d) + A^{\pm}_{nuis,2}$$

where the indices 1, 2 refer to a first wavelength and second wavelength respectively, $K_1$ and $K_2$ are the overlay K-factors of each wavelength, OV is the overlay to be determined and d is the target bias magnitude (e.g., a pair of biased target regions typically has equal bias magnitude and opposite bias direction). In intensity normalized space they may be written more conveniently as:

$$\frac{A^{\pm}_1}{\bar{I}_1} = \frac{SS_1(OV \pm d)}{d} + \frac{A^{\pm}_{nuis,1}}{\bar{I}_1} \text{ with } \vec{v}_1 = \left(A^+_{nuis,1}, A^-_{nuis,1}\right)/\bar{I}_1$$

$$\frac{A_2^{\pm}}{\bar{I}_2} = \frac{SS_2(OV \pm d)}{d} + \frac{A_{nuis,2}^{\pm}}{\bar{I}_2} \text{ with } \vec{v}_2 = \left(A_{nuis,2}^+, A_{nuis,2}^-\right)/\bar{I}_2$$

with $SS_1$ and $SS_2$ the stack sensitivities $\left(SS_{1,2} = K_{1,2}d \Big/ \bar{I}_{1,2}\right)$ , and $\bar{I}_1$ and $\bar{I}_2$ the average intensities of the first and second wavelength measurements respectively.

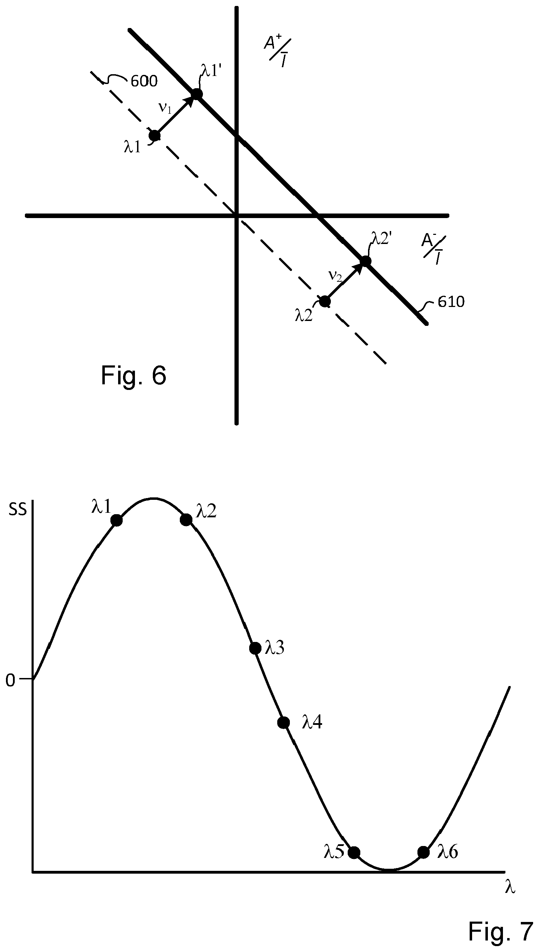

Figure 6 illustrates such an arrangement in A+/A- space; more specifically a plot of $A^+/\bar{I}$ against $A^-/\bar{I}$. Two wavelengths are plotted $\lambda 1$, $\lambda 2$ as would be seen in the absence of nuisance asymmetries, and a regression 600 plotted through the wavelengths. The same two wavelengths $\lambda 1'$, $\lambda 2'$ are plotted for the case where there is nuisance asymmetries present. The general achromatic intensity normalized nuisance assumption $\vec{v_1} = \vec{v_2}$ leads to the situation as depicted in Figure 6. In the known A+/A- regression method, a line 610 is regressed between these two (or more) wavelength entries $\lambda 1'$, $\lambda 2'$, with the resulting slope being used to compute overlay. This method relies on the stack sensitivity for the two wavelengths having opposite sign, such that the plots are in opposite quadrants in (normalized) A+/A- space. However, where this is not the case, e.g., where the stack sensitivity for the two wavelengths have the same sign, the problem becomes ill-conditioned. This is particularly the case if the stack sensitivities are of similar magnitude or even equal, the latter case presenting a singularity in A+/A- space making regression impossible. In such an event, this multi wavelength A+/A- regression completely breaks down.

However, it may be that better results (e.g., in terms of process robustness) may be obtained (for a given application) by using pairs of wavelengths corresponding to stack sensitivities of the same sign. Wavelengths having the same sign stack sensitivity for a given application will tend to be closer in wavelength space and therefore are more likely to be better correlated in terms of overlay error. Methods will now be described which enable overlay inference from pairs of same-signed stack sensitivity wavelengths. Furthermore, wavelength selection methods which exploit this possibility and the additional available wavelength combination space will also be described.

As such, described herein is a method of determining overlay from a weighted combination of overlay measurements, each overlay measurement relating to a different wavelength (or more generally measurement condition e.g., wavelength and polarization combination), the weighted combination being weighted by a stack sensitivity derived weighting. As such, instead of regressing in A+/A- space, overlay may be inferred from a weighted average of single wavelength overlay values, each corresponding to a single wavelength method.

Also described herein is a method of determining two or more wavelengths or more generally measurement condition) for performing an overlay measurement based on, for each wavelength, the derivative of a relationship between stack sensitivity and wavelength for a particular application (e.g., a particular stack and/or process).

Using stack sensitivity instead of the overlay K-factor is advantageous as it removes the effect of diffraction efficiency of the target from the equation due to the intensity normalization.

The proposed overlay inference and wavelength selection method may be used to suppress both sensor and target nuisance asymmetries at the same time.

Any nuisance asymmetry contribution to the overlay formula can be written in the following form for DBO (or micro-DBO $\mu$DBO):

$$OV_{measured} = d \left( \frac{A_{measured}^{+d} + A_{measured}^{-d}}{A_{measured}^{+d} - A_{measured}^{-d}} \right) = d \left( \frac{A_{OV}^{+d} + A_{OV}^{-d} + A_{nuis}^{offset}}{A_{OV}^{+d} - A_{OV}^{-d} + A_{nuis}^{scaling}} \right)$$

with $A_{nuis}^{offset}$ and $A_{nuis}^{scaling}$ the asymmetry errors introduced by the nuisances, which can originate from either sensor or target, and $A_{OV}^{+d}$ and $A_{OV}^{-d}$ the actual overlay target asymmetries (real overlay signal). The denominator of this formula equals $2Kd$, or $2\bar{I}SS$ with $\bar{I}$ the average intensity, in unperturbed state. The superscript *offset* refers to the nuisance component adding an offset to the inferred overlay value and the superscript *scaling* refers to a rescaling of the real overlay value into an inferred overlay value. The *offset* nuisance component usually generates pure tool induced shift (TIS), while the scaling nuisance component rescales both real overlay and (offset) TIS.

In a first order perturbative expansion the error propagation can be written as:

$$OV_{measured} = d\left(\frac{A_{measured}^{+d} + A_{measured}^{-d}}{A_{measured}^{+d} - A_{measured}^{-d}}\right) \approx OV\left(1 - \frac{A_{nuis}^{scaling}}{2Kd}\right) + \frac{A_{nuis}^{offset}d}{2Kd} - \frac{A_{nuis}^{offset}A_{nuis}^{scaling}d}{4K^2d^2}$$

$$= OV\left(1 - \frac{A_{nuis}^{scaling}}{2\bar{I}SS}\right) + \frac{A_{nuis}^{offset}d}{2\bar{I}SS} - \frac{A_{nuis}^{offset}A_{nuis}^{scaling}d}{4\bar{I}^2SS^2}$$

This perturbative expansion holds in the limit of $\left|A_{nuis}^{scaling}\right| \ll 2|K|d = 2\bar{I}|SS|$.

The nuisance asymmetries used in the overlay formula can be related to the nuisance asymmetries used in A+/A- via the following linear transformation:

$$\begin{bmatrix} A_{nuis}^{offset} \\ A_{nuis}^{scaling} \end{bmatrix} = \begin{bmatrix} 1 & 1 \\ 1 & -1 \end{bmatrix}\begin{bmatrix} A_{nuis}^{+} \\ A_{nuis}^{-} \end{bmatrix}$$

This shows both views are in fact identical and unique representations of the nuisances as the determinant is non-zero: $\det\left(\begin{bmatrix} 1 & 1 \\ 1 & -1 \end{bmatrix}\right) = -2$.

**Multi-wavelength inference by stack sensitivity magnitude weighted single wavelength overlay averaging**

By transferring from intensity normalized A+/A- space to overlay space, in combination with proper and physical weighing, a multi-wavelength overlay inference technique has been devised that operates both in the opposite and same-signed stack sensitivity regime. At the same time, this technique is capable of strongly suppressing the impact of the nuisance asymmetries on both overlay accuracy and machine to machine matching.

Transferring from vector A+/A- space to scalar overlay space typically involves moving from $A^{\pm}/\bar{I}$ units to $A^{\pm}/|K| = \frac{A^{\pm}d}{\bar{I}|SS|}$ units (apart from the sign). While it is then possible to average single-wavelength overlay of two (or more) wavelengths with same-signed stack sensitivity, the renormalization with $|SS|$ for each separate wavelengths leads to a different overlay impact for even perfectly achromatic intensity normalized nuisance asymmetries. As such, averaging multiple single-wavelength overlay entries into a multi-wavelength overlay result is very much alike to a slowly convergent series, particularly if the entries have alternating signs. An example of such a series is: $\ln(2) = 1 - \frac{1}{2} + \frac{1}{3} - \frac{1}{4} + \cdots$. This problem can be removed by using the following weights in a dual-wavelength averaging approach:

$$w_1 = \frac{|SS_1|}{|SS_1| + |SS_2|} \text{ and } w_2 = \frac{|SS_2|}{|SS_1| + |SS_2|}$$

In general, for a multi-wavelength embodiment, the weights may comprise:

$$w_i = \frac{|SS_i|}{\sum_j |SS_j|}$$

Where $|SS_i|$ represents the measured stack sensitivity magnitude of the target at wavelength i. It may be appreciated that a measured stack sensitivity value comprises an error caused by the $A_{nuis}^{scaling}$ nuisance asymmetry, as it is essentially the result of the overlay formula's denominator. It is very useful to have the weights already carry this nuisance error as will be shown below. It should be apparent that all weights are positive and its total sum equals 1. As such, this is a legitimate form of single-wavelength overlay averaging into a multi-wavelength overlay result.

A multi-wavelength overlay $OV_{MWL}$ value (overlay value inference) can then be determined from two or more single-wavelength overlay values $OV_{SWL,i}$ by:

$$OV_{MWL} = \sum_i w_i OV_{SWL,i}$$

This type of weighing reweighs all single-wavelength overlay values to the same magnitude impact in the case of perfectly achromatic intensity normalized nuisance asymmetries. The overlay errors scale inversely with stack sensitivity. By reweighing with stack sensitivity it is possible to remove the stack sensitivity effect and, for example, make all sensor errors the same magnitude for each wavelength.

**Nuisance suppression by proper stack sensitivity sign targeting**

The stack sensitivity $|SS|$ weighing essentially turns a slowly convergent series, as mentioned above, into a divergent series: 1 - 1 + 1 - 1 + ⋯. If it is assumed that this series is the accumulated overlay error of the single-wavelength nuisances, then it is apparent that the series should be truncated after the second (or other even numbered) wavelength entry, as 1 - 1 = 0. As such, a dual-wavelength approach using two wavelengths with opposite-signed stack sensitivity and perfect achromatic intensity normalized nuisance asymmetries may provide such a truncation scenario. It can also be appreciated that it may be beneficial to use an even number of wavelengths in such a multi-wavelength technique.

In the limit of zero programmed overlay (as is typical in a manufacturing setting) the nuisance suppression ability can be shown from the structure of the single-wavelength overlay error terms $\Delta OV_i$ for wavelengths $i$:

$$\Delta OV_1 = \frac{\left(\dfrac{A_{nuis,1}^{offset} d}{2\bar{I}_1}\right)}{SS_1 + \left(\dfrac{A_{nuis,1}^{scaling}}{2\bar{I}_1}\right)} = \frac{a_1}{SS_1 + b_1}$$

and

$$\Delta OV_2 = \frac{\left(\dfrac{A_{nuis,2}^{offset} d}{2\bar{I}_2}\right)}{SS_2 + \left(\dfrac{A_{nuis,2}^{scaling}}{2\bar{I}_2}\right)} = \frac{a_2}{SS_2 + b_2}$$

Stack sensitivity $|SS|$ weighted single-wavelength overlay averaging yields the following propagated overlay error:

$$\Delta OV_{DWL} = w_1 \Delta OV_1 + w_2 \Delta OV_2 = \frac{|SS_1 + b_1|\Delta OV_1 + |SS_2 + b_2|\Delta OV_2}{|SS_1 + b_1| + |SS_2 + b_2|}$$

$$= \frac{|SS_1 + b_1|\dfrac{a_1}{SS_1 + b_1} + |SS_2 + b_2|\dfrac{a_2}{SS_2 + b_2}}{|SS_1 + b_1| + |SS_2 + b_2|}$$

Without loss of generality, it is assumed here that stack sensitivity $SS_1$ at a first wavelength is positive. Depending on the relative sign of stack sensitivity $SS_2$ at a second wavelength (opposite-signed $OV_{DWL,opposite}$ or same-signed $\Delta OV_{DWL,same}$), this computes to:

$$\Delta OV_{DWL,opposite} = \frac{(a_1 - a_2)}{(SS_1 - SS_2) + (b_1 - b_2)}$$

$$\Delta OV_{DWL,same} = \frac{(a_1 + a_2)}{(SS_1 + SS_2) + (b_1 + b_2)}$$

It is therefore apparent that the resulting dual-wavelength (or even-numbered multi-wavelength) accumulated overlay error due to nuisances can be perfectly zeroed in either scenario provided that either $a_1 - a_2 = 0$ (for opposite-signed stack sensitivity) or $a_1 + a_2 = 0$ (for same-signed stack sensitivity). In case of a perfectly achromatic intensity normalized nuisance asymmetry ($a_1 = a_2$) it is therefore apparent that opposite-signed stack sensitivity weighing may be best for such a dual-wavelength case. In a general real-world setting $a_1 \neq a_2$; however provided that there is no sign flip, wavelengths having opposite-signed stack sensitivity may be used.

**Optimizing Process Robustness**

While the implication of the above embodiment is that opposite-signed stack sensitivity is preferred, this is not necessarily always the case. While opposite-signed stack sensitivity may be beneficial from the perspective of accuracy in terms of reducing mean overlay error over the wafer, it is not necessarily the best choice from the perspective of accuracy in terms of error variation over the wafer; e.g., in terms of the standard deviation $\sigma$ of the error over the wafer (e.g., in terms of $3\sigma$). In fact, it may be preferable in many applications to reduce error variation over a wafer, rather than the absolute error magnitude. If the error is relatively stable over the wafer, it is relatively simple to correct via cheap metrology (only sparse metrology is required to characterize and correct for such a stable error). As such, a further embodiment is directed to improving process robustness (minimizing error variance over each wafer) rather than simply minimizing the error magnitude.

In order to be process robust (e.g., low overlay error variation), the $\Delta OV_{DWL,opposite}$ expression should be stable under at least first order process perturbation. This means that $\Delta OV_{DWL,opposite}$ for measurement $k$ should be highly independent of the process excursion $\Delta p_k$ (where process excursion describes variation in a process parameter on which stack sensitivity is dependent, e.g., thickness or refractive index variation):

$$\Delta OV_{DWL,opposite,k} = \frac{(a_1 - a_2)}{(SS_{1,k} - SS_{2,k}) + (b_1 - b_2)} = \frac{(a_1 - a_2)}{(SS_1 + \beta_1 \Delta p_k - SS_2 - \beta_2 \Delta p_k) + (b_1 - b_2)}$$

This leads to the following criterion:

$$SS_1 - SS_2 + \Delta p_k (\beta_1 - \beta_2) = constant \xrightarrow{yields} \beta_2 = \beta_1$$

This means that for dual-wavelength overlay inference using opposite-signed stack sensitivity wavelengths, it is advantageous for the process derivatives $\beta_1$, $\beta_2$ corresponding to each wavelength to be same-signed and have a similar or same magnitude. As such, where the stack sensitivity is different signed, the wavelengths may be chosen such that the process derivatives are same-signed and the difference in their magnitude is minimized.

Similarly, when the stack sensitivity is same-signed, the $\Delta OV_{DWL,same}$ expression should be stable under at least first order process perturbation. This means that $\Delta OV_{DWL,same}$ for measurement k needs to be highly independent of the process excursion $\Delta p_k$:

$$\Delta OV_{DWL,same,k} = \frac{(a_1 + a_2)}{(SS_{1,k} + SS_{2,k}) + (b_1 + b_2)} = \frac{(a_1 + a_2)}{(SS_1 + \beta_1 \Delta p_k + SS_2 + \beta_2 \Delta p_k) + (b_1 + b_2)}$$

This leads to the following criterion:

$$SS_1 + SS_2 + \Delta p_k (\beta_1 + \beta_2) = constant \xrightarrow{yields} \beta_2 = -\beta_1$$

This means that for dual-wavelength overlay inference using same-signed stack sensitivity wavelengths, it is advantageous for the process derivatives $\beta_1, \beta_2$ corresponding to each wavelength to be opposite-signed and have a similar or same magnitude. As such, where the stack sensitivity is same-signed, the wavelengths may be chosen such that the process derivatives are opposite-signed and the difference in their magnitude is minimized.

## Relation to stack sensitivity swing curve

While it may be intuitive to assume the process derivatives $\beta_1, \beta_2$ in the previous section are identical to the stack sensitivity swing curve (stack sensitivity plotted against wavelength) derivatives with respect to wavelengths, this is not really true. The situation is slightly more complex, but this additional complexity level is important for understanding the mechanism of process dephasing on multi-wavelength scenarios. This is the process equivalent of longitudinal coherence in optics: distances in wavelengths space start to matter.

Assuming that the stack sensitivity is described by a swing curve $SS(\lambda)$, with $\lambda$ being the wavelength and function $g_{same}$ is to be minimized, where $g_{same}$ is the sum of two shifted versions of function $f$, which in turn is a function of $SS(\lambda)$. Therefore, for two wavelengths $\lambda_1$ and $\lambda_2$, the desired minimization is described by:

$$g_{same}(\lambda_1, \lambda_2) = f\big(SS(\lambda_1)\big) + f\big(SS(\lambda_2)\big) = 0$$

Defining $\lambda_1 = \lambda_c - \dfrac{\lambda_s}{2}$ and $\lambda_2 = \lambda_c + \dfrac{\lambda_s}{2}$, with $\lambda_c$ the center wavelengths and $\lambda_s$ the (positive-defined) wavelengths separation, yields:

$$g_{same}(\lambda_c, \lambda_s) = f\left(SS\left(\lambda_c - \frac{\lambda_s}{2}\right)\right) + f\left(SS\left(\lambda_c + \frac{\lambda_s}{2}\right)\right) = 0$$

A perturbative Taylor series expansion then gives up to first order:

$$g_{same}(\lambda_c + \Delta\lambda_c, \lambda_s + \Delta\lambda_s)$$
$$= g_{same}(\lambda_c, \lambda_s) + \left(\frac{\partial g_{same}}{\partial \lambda_c}\right)\Delta\lambda_c + \left(\frac{\partial g_{same}}{\partial \lambda_s}\right)\Delta\lambda_s + O\left([\Delta\lambda_c]^2, [\Delta\lambda_s]^2, \Delta\lambda_c\Delta\lambda_s\right)$$

where $O$ describes residual terms of higher order, which are to be neglected

Maintaining $g_{same}$ to remain balanced up to first order perturbation requires:

$$\left(\frac{\partial g_{same}}{\partial \lambda_c}\right)\Delta\lambda_c + \left(\frac{\partial g_{same}}{\partial \lambda_s}\right)\Delta\lambda_s = 0$$

This indicates the following being stabilized:

$$\left[\left(\frac{\partial f}{\partial SS\left(\lambda_c - \frac{\lambda_s}{2}\right)}\right)\left(\frac{\partial SS\left(\lambda_c - \frac{\lambda_s}{2}\right)}{\partial \lambda_c}\right) + \left(\frac{\partial f}{\partial SS\left(\lambda_c + \frac{\lambda_s}{2}\right)}\right)\left(\frac{\partial SS\left(\lambda_c + \frac{\lambda_s}{2}\right)}{\partial \lambda_c}\right)\right]\Delta\lambda_c$$
$$+ \left[\left(\frac{\partial f}{\partial SS\left(\lambda_c - \frac{\lambda_s}{2}\right)}\right)\left(\frac{\partial SS\left(\lambda_c - \frac{\lambda_s}{2}\right)}{\partial \lambda_s}\right) + \left(\frac{\partial f}{\partial SS\left(\lambda_c + \frac{\lambda_s}{2}\right)}\right)\left(\frac{\partial SS\left(\lambda_c + \frac{\lambda_s}{2}\right)}{\partial \lambda_s}\right)\right]\Delta\lambda_s$$
$$= 0$$

The first term of this equation relates to the sensitivity to swing curve shift, as expressed by the center wavelengths shift parameter $\Delta\lambda_c$. The second term of this equation relates to the sensitivity to swing curve period change, as expressed by the wavelengths separation parameter $\Delta\lambda_s$. In case of e.g., a layer thickness variation as the relevant process effect, the swing curve will both shift and change its period, as expressed by both parameters $\Delta\lambda_c$ and $\Delta\lambda_s$.

Where there is only a shift $\Delta\lambda_c$, but no material period change $\Delta\lambda_s$, then:

$$\frac{\partial SS(\lambda_1)}{\partial \lambda} = - \left[ \frac{\frac{\partial f}{\partial SS(\lambda_2)}}{\frac{\partial f}{\partial SS(\lambda_1)}} \right] \frac{\partial SS(\lambda_2)}{\partial \lambda}$$

If $f$ only depends on linear $SS$ terms (so no $SS^n$ terms with $n > 1$) it can be shown that:

$$\frac{\partial f}{\partial SS(\lambda_1)} = \frac{\partial f}{\partial SS(\lambda_2)}$$

as long as both stack sensitivity are non-zero. Hence it is desirable if the SS swing curve derivatives are equal in magnitude and opposite-signed; i.e.:

$$\frac{\partial SS(\lambda_1)}{\partial \lambda} = -\frac{\partial SS(\lambda_2)}{\partial \lambda}$$

Where there is only a period change $\Delta\lambda_s$, but no material shift $\Delta\lambda_c$, then:

$$-\frac{1}{2}\frac{\partial SS(\lambda_1)}{\partial \lambda} = - \left[ \frac{\frac{\partial f}{\partial SS(\lambda_2)}}{\frac{\partial f}{\partial SS(\lambda_1)}} \right] \frac{1}{2}\frac{\partial SS(\lambda_2)}{\partial \lambda} \xrightarrow{yields} \frac{\partial SS(\lambda_1)}{\partial \lambda} = \left[ \frac{\frac{\partial f}{\partial SS(\lambda_2)}}{\frac{\partial f}{\partial SS(\lambda_1)}} \right] \frac{\partial SS(\lambda_2)}{\partial \lambda}$$

Hence it is desirable if the SS swing curve derivatives are equal (in sign and magnitude) i.e.:

$$\frac{\partial SS(\lambda_1)}{\partial \lambda} = \frac{\partial SS(\lambda_2)}{\partial \lambda}$$

This shows that, in the case of same-signed stack sensitivity dual-wavelength overlay inference, the process derivative requirement ($\beta_2 = -\beta_1$) is compatible with a pure shift of the stack sensitivity swing curve, but incompatible with a pure period change of the stack sensitivity swing curve.

For the opposite-signed stack sensitivity dual-wavelength case, the situation is exactly the same as the stack sensitivity sign flip also causes a sign flip between $f(SS(\lambda_1))$ and $f(SS(\lambda_2))$ resulting in:

$$g_{opposite}(\lambda_1, \lambda_2) = f\big(SS(\lambda_1)\big) - f\big(SS(\lambda_2)\big) = 0$$

which, in turn, shows that the process derivative requirement ($\beta_2 = \beta_1$) is again compatible with a pure shift of the stack sensitivity swing curve, but incompatible with a pure period change of the stack sensitivity swing curve. Obviously, only when all derivatives (with respect to the process parameter and the stack sensitivity swing curve) are zero will all criteria converge.

While targeting extrema may be useful for opposite-signed stack sensitivity dual-wavelength cases, it is usually not very attractive for same-signed stack sensitivity dual-wavelength cases as the two chosen wavelengths then need to correspond to either two peaks or two valleys, which will be very far apart in wavelengths space (at least one full period of the stack sensitivity swing curve). Targeting extrema is more suited for opposite-signed stack sensitivity dual-wavelength cases, as the two wavelengths are then generally closer in wavelengths space (half period of stack sensitivity swing curve).

In reality, a process excursion $\Delta p_k$ will trigger both a stack sensitivity swing curve shift and period change at the same time. The greater the separation in wavelengths space of the two selected wavelengths for the dual-wavelength case (or pairs in a multi-wavelength case), the more the process excursion will de-phase / suppress correlation between the first wavelength and second wavelength in terms of stack sensitivity swing curve behavior when evaluated over the whole wafer. Since successful suppression of error variation over a wafer (good $3\sigma$ performance) relies on a well-targeted correlation coefficient, as measured across the whole wafer, any dephasing will negatively impact the final result. As such, two wavelengths that are further apart will be more likely to show poor correlation. For opposite-signed stack sensitivity dual-wavelength cases, a +1 correlation coefficient is desirable, whereas for same-signed stack sensitivity dual-wavelength cases, a -1 correlation coefficient is desirable for error variation suppression.

Therefore, in summary of this embodiment, it may be preferable to use pairs of wavelengths which stabilize each other in terms of process robustness. This may be achieved by selecting wavelengths for which the difference in respective magnitudes of the derivative of the stack sensitivity swing curve is minimized. Where more than one pair of wavelengths is used for a measurement, each pair may be chosen such that a first wavelength of each pair is stabilized by a second wavelength of each pair. This may be achieved by selecting the wavelengths of each pair as those having SS swing curve derivatives of similar magnitude. As such the wavelengths may be chosen such that a first derivative of stack sensitivity with respect to wavelength corresponding to the first wavelength of each pair has a similar magnitude to a second derivative of stack sensitivity with respect to wavelength corresponding to a second wavelength of each pair. Similar in this context may comprise respective derivatives not differing in magnitude by more than 30%, 20%, 15%, 10%, 5%, 4%, 3%, 2% or 1%. Alternatively or in addition, it may be preferable to minimize distance between the wavelengths of each pair of wavelengths. This may be easier to achieve using wavelengths corresponding to the same-signed stack sensitivity. Using a pair of wavelengths of same-signed stack sensitivity may result in a larger mean overlay error (as errors may add rather than subtract), however this may be preferable to achieve good process robustness for reasons already described.

**Resulting multi-wavelength strategies of stack sensitivity weighted single-wavelength overlay averaging**

Figure 7 is a stack sensitivity swing curve comprising a plot of stack sensitivity SS against wavelength λ. Six example wavelengths are shown λ1-λ6, and this section will describe possible strategies for selecting a pair of wavelengths for an overlay measurement (e.g., using the stack sensitivity magnitude |*SS*| weighing strategies disclosed herein) from these six wavelengths. The table below summarizes the merits of each wavelength pair.

| dual-wavelength combination | λ1 + λ2 or λ5 + λ6 | λ2 + λ5 | λ3 + λ4 |
|---|---|---|---|
| **Sign of stack sensitivity** | Same | **Opposite** | **Opposite** |
| **(pure sign suppression)** | | | |
| **Magnitude of stack sensitivity / stack sensitivity swing curve derivative** | **High / low** | **High / low** | Low / High |
| **Process decorrelation (∝ wavelength spacing)** | **Low** | High | **Low** |
| **wavelengths switching speed (∝ wavelength spacing)** | **Fast** | Slow | **Fast** |

The entries in bold/underline indicate that the property is desirable. For example, a high magnitude of stack sensitivity suppresses overlay errors resulting from a fixed (intensity normalized) nuisance asymmetry and a low derivative with respect to wavelength reduces sensitivity to small wavelength variation. It can be seen that each wavelength pair has its merits, but none fulfill all desirable aspects at the same time. As has been described, the methods disclosed herein extend the solution space for wavelength selection; the wavelength pair λ1 + λ2 and wavelength pair λ5 + λ6 (first column) are simply not a valid choice for A+/A- regression. However, in many cases one of these pairs may actually be advantageous, e.g., to increase robustness. At the same time, it has also been shown that opposite-signed stack sensitivity can be a good strategy provided that the intensity normalized nuisance asymmetries are sufficiently achromatic between the wavelengths chosen.

Each combination (or a number of combinations which meet one or more desirable criteria such as opposite-signed stack sensitivity or low stack sensitivity swing curve derivative) can be evaluated experimentally (through real measurement and/or simulation) to determine a best performing combination.

While the targets described above are metrology targets specifically designed and formed for the purposes of measurement, in other embodiments, properties may be measured on targets which are functional parts of devices formed on the substrate. Many devices have regular, grating-like structures. The terms 'target grating' and 'target' as used herein do not require that the structure has been provided specifically for the measurement being performed. In such an embodiment, either the target gratings and mediator grating may all comprise product structure, or only one or both target gratings comprise product structure, with the mediator grating being specifically formed to mediate the allowable pitches, and therefore enable measurements directly on the product structure. Further, pitch of the metrology targets is close to the resolution limit of the optical system of the scatterometer, but may be much larger than the dimension of typical product features made by lithographic process in the target portions C. In practice the lines and/or spaces of the overlay gratings within the targets may be made to include smaller structures similar in dimension to the product features.

An embodiment may include a computer program containing one or more sequences of machine-readable instructions describing methods of measuring targets on a substrate and/or analyzing measurements to obtain information about a lithographic process. This computer program may be executed for example within unit PU in the apparatus of Figure 3 and/or the control unit LACU of Figure 2. There may also be provided a data storage medium (e.g., semiconductor memory, magnetic or optical disk) having such a computer program stored therein. Where an existing metrology apparatus, for example of the type shown in Figure 3, is already in production and/or in use, the invention can be implemented by the provision of updated computer program products for causing a processor to perform the steps necessary to calculate the overlay error.

The program may optionally be arranged to control the optical system, substrate support and the like to perform the steps necessary to calculate the overlay error for measurement of asymmetry on a suitable plurality of targets.

Further embodiments according to the present invention are described in below numbered clauses:

16. A method of selecting two or more measurement wavelengths for measuring a parameter of interest from a target on a substrate, the method comprising:

obtaining swing curve data describing stack sensitivity of the target in relation to wavelength;
and selecting said two or more measurement wavelengths based on at least the derivative of the stack sensitivity with respect to wavelength.

17. A method according to clause 16, wherein said two or more measurement wavelengths comprise one or more pairs of wavelengths; and wherein each pair of said one or more pairs of wavelengths are selected so as to minimize the difference between a magnitude of a first said derivative corresponding to a first wavelength of the pair and a magnitude of a second said derivative corresponding to a second wavelength of the pair.

18. A method according to clause 17, wherein the first said derivative and the second said derivative are opposite-signed for at least one of said one or more pairs of wavelengths.

19. A method according to clause 17, wherein the first said derivative and the second said derivative are same-signed for at least one of said one or more pairs of wavelengths.

20. A method according to any of clauses 17 to 19, wherein a difference between the first wavelength and second wavelength is smaller than 100nm for at least one of said one or more pairs of wavelengths.

21. A method according to any of clauses 17 to 19, wherein a difference between the first wavelength and second wavelength is smaller than 50nm for at least one of said one or more pairs of wavelengths.

22. A method according to any of clauses 16 to 21, wherein each of the selected measurement wavelengths relate to same-signed stack sensitivity for said target.

23. A method according to any of clauses 16 to 21, wherein at least two of the selected measurement wavelengths relate to different-signed stack sensitivity for said target.

24. A method according to any of clauses 16 to 23, wherein the number of selected measurement wavelengths is even.

25. A method according to any of clauses 16 to 24, wherein the number of selected measurement wavelengths is two.

26. A method according to any of clauses 16 to 25, wherein the parameter of interest is overlay.

27. A method according to any of clauses 16 to 26, comprising measuring said target using each the selected measurement wavelength to obtain metrology data.

28. A method according to clause 27, wherein said metrology data comprises at least a respective single-wavelength parameter of interest values for each selected measurement wavelength; and the method further comprises: determining said value for the parameter of interest from a weighted combination of said single-wavelength parameter of interest values, the weighted combination being weighted by a stack sensitivity derived weighting.

29. A method according to clause 28, wherein the weighting for each single-wavelength parameter of interest value comprises a ratio of the magnitude of stack sensitivity corresponding to the measurement wavelength used to obtain that single-wavelength parameter of interest value to the sum of the magnitudes of stack sensitivities for all of said selected measurement wavelengths.

30. A method according to clause 28 or 29, wherein said combination suppresses the magnitude and/or mean of a measurement error resultant from nuisance contributions to the parameter of interest resulting from imperfections in the target and/or a tool used to measure the target.

31. A method according to clause 28, 29 or 30, wherein the combination suppresses the variation across a substrate of a measurement error resultant from nuisance contributions to the parameter of interest resulting from imperfections in the target and/or a tool used to measure the target.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), A well A particle beams, such A ion beams or electron beams.

The term "lens", where the context allows, may refer to any one or combination of various types of components, including refractive, reflective, magnetic, electromagnetic and electrostatic components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of determining a value for a parameter of interest from a target on a substrate, the method comprising: obtaining metrology data comprising at least two or more single-wavelength parameter of interest values, each single-wavelength parameter of interest value having been obtained using a respective different measurement wavelength; and determining said value for the parameter of interest from a weighted combination of said single-wavelength parameter of interest values, the weighted combination being weighted by a stack sensitivity derived weighting.

2. A method as claimed in claim 1, wherein the parameter of interest is overlay.

3. A method as claimed in claim 1 or 2, wherein the weighting for each single-wavelength parameter of interest value comprises a ratio of the magnitude of stack sensitivity corresponding to the measurement wavelength used to obtain that single-wavelength parameter of interest value to the sum of the magnitudes of stack sensitivities for all of said measurement wavelengths.

4. A method as claimed in any preceding claim, wherein said combination suppresses the magnitude and/or mean of a measurement error resultant from nuisance contributions to the parameter of interest resulting from imperfections in the target and/or a tool used to measure the target.

5. A method as claimed in any preceding claim, wherein the combination suppresses the variation across a substrate of a measurement error resultant from nuisance contributions to the parameter of interest resulting from imperfections in the target and/or a tool used to measure the target.

6. A method as claimed in any preceding claim, wherein said different measurement wavelengths comprise one or more pairs of wavelengths; and wherein a first derivative of stack sensitivity with respect to wavelength corresponding to the first wavelength of each pair has a similar magnitude to a second derivative of stack sensitivity with respect to wavelength corresponding to a second wavelength of each pair.

7. A method as claimed in claim 6, wherein said first derivative and said second derivative are opposite-signed for at least one of said one or more pairs of wavelengths.

8. A method as claimed in claim 6, wherein said first derivative and said second derivative is same-signed for at least one of said one or more pairs of wavelengths.

9. A method as claimed in claim 6, 7 or 8, wherein a difference between the first wavelength and second wavelength is smaller than 100nm for at least one of said one or more pairs of wavelengths.

10. A method as claimed in claim 6, 7 or 8, wherein a difference between the first wavelength and second wavelength is smaller than 50nm for at least one of said one or more pairs of wavelengths.

11. A method as claimed in any preceding claim, wherein said different measurement wavelengths all correspond to a same-signed stack sensitivity for said target.

12. A method as claimed in any preceding claim, comprising measuring said target using each said different measurement wavelength to obtain said metrology data.

13. A processing apparatus comprising a processor, and being configured to perform the method of any preceding claim.

14. A metrology apparatus comprising the processor of claim 13.

15. A computer program comprising program instructions operable to perform the method of any of claims 1 to 12, when run on a suitable apparatus.

Fig. 1

Fig. 2

(a)

(b)    (c)    (d)

Fig. 3

Fig. 4

Fig. 5

Fig. 6

Fig. 7

Europäisches
Patentamt

European
Patent Office

Office européen
des brevets

# EUROPEAN SEARCH REPORT

Application Number

EP 22 15 5168

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/008135 A1 (ASML NETHERLANDS BV [NL]) 13 January 2022 (2022-01-13) | 1,2, 12-15 | INV. G03F7/20 G03F9/00 |
| Y | * paragraph [0028] – paragraph [0080] * * figures 2,3a,9 * | 3-11 | |
| Y | US 2018/017881 A1 (VAN DER SCHAAR MAURITS [NL] ET AL) 18 January 2018 (2018-01-18) | 3 | |
| A | * paragraphs [0142], [0143]; figure 17A * | 1,13,15 | |
| Y | EP 3 605 230 A1 (STICHTING VU [NL] ET AL.) 5 February 2020 (2020-02-05) | 4,5 | |
| A | * paragraph [0070] – paragraph [0073] * * figure 7 * | 1,13,15 | |
| Y | EP 3 444 676 A1 (ASML NETHERLANDS BV [NL]) 20 February 2019 (2019-02-20) | 6-11 | |
| A | * paragraph [0042]; figure 7 * | 1,13,15 | |

TECHNICAL FIELDS
SEARCHED      (IPC)

G03F

The present search report has been drawn up for all claims

| Place of search | Date of completion of the search | Examiner |
|---|---|---|
| Munich | 19 July 2022 | Meixner, Matthias |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
................................................................
& : member of the same patent family, corresponding
    document

EPO FORM 1503 03.82 (P04C01)

EP 4 224 254 A1

## ANNEX TO THE EUROPEAN SEARCH REPORT
## ON EUROPEAN PATENT APPLICATION NO.

EP 22 15 5168

This annex lists the patent family members relating to the patent documents cited in the above-mentioned European search report.
The members are as contained in the European Patent Office EDP file on
The European Patent Office is in no way liable for these particulars which are merely given for the purpose of information.

19-07-2022

| Patent document cited in search report | | Publication date | Patent family member(s) | | Publication date |
|---|---|---|---|---|---|
| WO 2022008135 | A1 | 13-01-2022 | TW | 202209006 A | 01-03-2022 |
| | | | WO | 2022008135 A1 | 13-01-2022 |
| US 2018017881 | A1 | 18-01-2018 | CN | 109478023 A | 15-03-2019 |
| | | | CN | 113552779 A | 26-10-2021 |
| | | | IL | 263765 A | 31-01-2019 |
| | | | KR | 20190029698 A | 20-03-2019 |
| | | | TW | 201812468 A | 01-04-2018 |
| | | | US | 2018017881 A1 | 18-01-2018 |
| | | | US | 2020033741 A1 | 30-01-2020 |
| | | | WO | 2018010979 A1 | 18-01-2018 |
| EP 3605230 | A1 | 05-02-2020 | NONE | | |
| EP 3444676 | A1 | 20-02-2019 | EP | 3444676 A1 | 20-02-2019 |
| | | | TW | 201921137 A | 01-06-2019 |
| | | | US | 2019056220 A1 | 21-02-2019 |
| | | | WO | 2019034411 A1 | 21-02-2019 |

EPO FORM P0459

For more details about this annex : see Official Journal of the European Patent Office, No. 12/82

# EP 4 224 254 A1

## REFERENCES CITED IN THE DESCRIPTION

### Patent documents cited in the description

- WO 2009078708 A
- WO 2009106279 A
- US 20110027704 A
- US 20110043791 A
- US 20120242970 A
- US 2010201963 A1
- US 2011102753 A1
- WO 2015018625 A1